# EUROPEAN PATENT APPLICATION

(11) **EP 4 570 970 A1**
(43) Date of publication of application: **18.06.2025**
(21) Application number: 24804400.0
(22) Date of filing: 24.05.2024
(51) Int. Cl.: C30B 29/36

(54) **HIGH UNIFORMITY SIC CRYSTAL, CRYSTAL BAR, SUBSTRATE, AND SEMICONDUCTOR DEVICE**

(30) Priority: 09.10.2023 CN 202311294326; 03.11.2023 CN 202311464895; 11.05.2024 CN 202410579039
(71) Applicant: SICC CO., LTD., Jinan, Shandong 250118 (CN)
(72) Inventor: GAO, Chao, Jinan, Shandong 250118 (CN); PAN, Yani, Jinan, Shandong 250118 (CN); NING, Xiuxiu, Jinan, Shandong 250118 (CN); GAO, Yuhan, Jinan, Shandong 250118 (CN); YANG, Xiaoli, Jinan, Shandong 250118 (CN); SHI, Zhiqiang, Jinan, Shandong 250118 (CN)
(74) Representative: Huang, Liwei
(86) International application number: PCT/CN2024/095184
(87) International publication number: WO 2025/077204

(57) **Abstract**

The present invention provides a high-uniformity SiC crystal, a crystal bar, a substrate and a semiconductor device and relates to the technical field of silicon carbide wafers. The SiC crystal is obtained by direct growth through a PVT method without subsequent machining, and includes a facet region and a non-facet region. The facet region is located on an outer circumference of the SiC crystal. A doping concentration change rate of the facet region is 1.5 times or above that of the non-facet region; and/or a carrier concentration change rate of the facet region is 5 times or above that of the non-facet region. The facet region is removed in a subsequent crystal machining process, the facet region does not exist on the whole crystal bar as well as a wafer and a substrate which are obtained after subsequent machining with a low cut loss rate, and a higher yield, higher performance and higher reliability of a device end are guaranteed.

## Description

### CROSS REFERENCE TO THE RELATED APPLICATIONS

The present invention claims priorities to Chinese Patent Application No. 202311294326.5, filed with CNIPA on October 09, 2023 and entitled "HIGH-UNIFORMITY SILICON CARBIDE SUBSTRATE AND SEMIDONDUCTOR DEVICE" and Chinese Patent Application No. 202311464895.X, filed with CNIPA on November 03, 2023 and entitled "SiC CRYSTAL WITH FACET ONLY AT EDGE, WAFER THEREOF AND SEMICONDUCTOR DEVICE", the entire contents of which are incorporated herein by reference.

### TECHNICAL FIELD

The present invention relates to the technical field of silicon carbide wafers, in particular to a high-uniformity SiC crystal, a crystal bar, a substrate and a semiconductor device.

### BACKGROUND

A silicon carbide semiconductor is of great interest due to its excellent physical performance such as a large band gap, a high breakdown field strength and a high thermal conductivity. A power device prepared based on a silicon carbide monocrystal substrate has excellent performance such as resistance to a high voltage, resistance to a high temperature and low loss, thereby being widely applied to industrial fields such as new energy automobiles, photovoltaic industry and power grid. Through technological and industrial development in years, a silicon carbide monocrystal preparation technology has made great progress, but there are still some problems, including: 1, a quality problem, which affects a yield, performance and reliability of a silicon carbide device end; and 2, a cost problem, which affects application of silicon carbide in a terminal. Material and device yield loss caused by quality of materials is also a main cause of high cost and difficult application of silicon carbide at present.

Further, the quality problem of the silicon carbide includes two kinds: one is an explicit quality problem of material quality and yield caused by a defect problem, which may be reflected well in a crystal material index; and the other is a reliability problem of material yield, device performance and the like caused by a quality consistency problem, which is difficult to reflect in the crystal material index and thus brings a greater risk to reliability of a subsequent device in application.

A facet is an inherent attribute existing when a SiC crystal is prepared by a sublimation method, such facet exists on a SiC crystal and wafer prepared by a conventional physical vapor transportation method (PVT for short), and a facet region has a higher doping concentration than other regions, so a carrier concentration and electrical resistivity of the facet region are obviously different from those of the other regions, which causes electrical performance and a defect state of the facet region to be prone to an abnormity quality problem.

The facet is commonly known as "growth characteristic face", "growth facet", "characteristic growth face", etc. in the art, and the facet in the present invention does not refer to a growth interface.

Therefore, a goal of sustainable development of a silicon carbide crystal material is to improve quality and reduce cost. Especially in a stage of making the silicon carbide industry to quickly step into large-scale production and application at present, stability, consistency and reliability of performance of the silicon carbide material will play a significant role in industrial development. The present invention focuses on the problem of consistency of the electrical property during preparation of silicon carbide monocrystal and aims to solve the problem of inconsistency of the electrical property caused by an intrinsic property during silicon carbide growth and a hidden danger of performance and reliability of a device end caused possibly thereby.

### SUMMARY

In order to solve the above problems, a first aspect of the present invention provides a SiC crystal with facets only in edge area. The SiC crystal is obtained through direct growth by a PVT method without subsequent machining. The SiC crystal includes a facet region a non-facet region. The facet region is located on an outer circumference of the SiC crystal. The whole area of the facet region meets any one or two of the following items a to b:
a, a doping concentration change rate of the facet region is 1.5 times or above a doping concentration change rate of the non-facet region; and
b, a carrier concentration change rate of the facet region is 5 times or above a carrier concentration change rate of the non-facet region.

The outer circumference refers to an edge position of a lateral growth of the crystal, or is called an edge position of the crystal.

In some embodiments, a distance between an edge of the facet region away from the outer circumference and the outer circumference does not exceed 3% of a diameter of the SiC crystal. In some embodiments, a distance between an edge of the facet region away from the outer circumference and the outer circumference does not exceed 2% of a diameter of the SiC crystal. The edge of the face region away from the outer circumference refers to an end of the facet region close to a center of the silicon carbide crystal.

In some embodiments, a maximum sectional area of the facet region accounts for 10% or below of a cross sectional area of the crystal in a diameter direction, and/or
a volume of the facet region accounts for 2% or below of a volume of the whole crystal. For example, the facet region may be located at an edge of an oblique upper corner or an oblique lower corner of the crystal.

In some embodiments, a maximum sectional area of the facet region accounts for 5% or below of a cross sectional area of the crystal in a diameter direction, and/or
a volume of the facet region accounts for 0.6% or below of a volume of the whole crystal. A whole shape of the facet region may be a triangle, a cone, a sphere, a spheroidicity or a rhombus. A cross section of the facet region in the diameter direction may be elliptical, crescent-shaped, circular or the like, however, the present invention is not limited to this.

In some embodiments, TDV of the facet region is 6 times or above TDV of the non-facet region; or TDV of the facet region is 10 times or above TDV of the non-facet region.

In some embodiments, a doping concentration change rate of the facet region is 5 times or above a doping concentration change rate of the non-facet region; and/or a carrier concentration change rate of the facet region is 10 times or above a carrier concentration change rate of the non-facet region.

In the SiC crystal with the facet only at an edge in the present invention, the facet region is directly fixed to the edge of the crystal in a growth process by the PVT method, a cut loss rate of the subsequent silicon carbide crystal is reduced, and production cost is reduced.

A second aspect of the present invention provides a facet-free silicon carbide crystal bar. The facet-free silicon carbide crystal bar is obtained by removing a facet region of the SiC crystal with facets only in edge area.

A third aspect of the present invention provides a SiC wafer. The SiC wafer is obtained by removing the facet region of the SiC crystal with facets only in edge area to obtain the facet-free silicon carbide crystal bar and then cutting the facet-free silicon carbide crystal bar. Any one or two or more of the facet, a highly-doped region and a defect accumulation region are not included within a full area region of the SiC wafer.

The highly-doped region refers to a "birthmark"-like black spot visible to the naked eyes in the silicon carbide wafer where a doping concentration is greater than a doping concentration of the non-facet region; and the defect accumulation region refers to a "birthmark"-like black spot visible to the naked eyes in the silicon carbide wafer where a defect density is greater than a defect density of the non-facet region.

In some embodiments, the SiC wafer has an in-plane doping concentration change rate less than 10%; and/or an in-plane carrier concentration change rate less than 5%.

In some embodiments, the SiC wafer has an in-plane doping concentration change rate less than 8%; and/or an in-plane carrier concentration change rate less than 3%.

In some embodiments, the SiC wafer has a TDV density of less than 100 cm⁻². In some embodiments, the silicon carbide wafer has a TDV density of less than 10cm⁻².

In some embodiments, the SiC wafer is a silicon carbide wafer with any thickness. For example, the SiC wafer has a thickness not less than 200 µm; or the silicon carbide wafer has a thickness not less than 300 µm; or the silicon carbide wafer has a thickness not less than 400 µm.

In some embodiments, the SiC wafer may be N₂-doped or codoped with any other element. For example, nitrogen may be codoped with any one or two or more elements of P, As, Ge, Sn, B and Al, and the prepared silicon carbide wafer is of a conductive type.

In some embodiments, the wafer has a size of 4 inches, 6 inches, 8 inches, 10 inches or 12 inches.

In some embodiments, the silicon carbide wafer has a basal plane dislocation (BPD for short) total density variation less than 50 cm⁻². In some embodiments, the silicon carbide wafer has a BPD total density variation less than 20 cm⁻². In some embodiments, the silicon carbide wafer has a BPD total density variation less than 10 cm⁻². The BPD total density variation is "an in-plane BPD density maximum value of the silicon carbide wafer minus an in-plane BPD density minimum value of the silicon carbide wafer".

A fourth aspect of the present invention provides a high-uniformity silicon carbide substrate. The high-uniformity silicon carbide substrate is obtained by machining the above SiC crystal. The silicon carbide substrate is of a conductive type. The whole area of the silicon carbide substrate meets any one or two of the following items a to b:
a, the doping concentration change rate is less than 10%; and
b, the carrier concentration change rate is less than 5%.

In some embodiments, the silicon carbide substrate is n-type doping, an n-type element doping concentration is greater than or equal to 1E18 cm⁻³, and any one or two of a highly-doped region and a defect accumulation region are not included within the full area range. The silicon carbide substrate is obtained by a PVT method.

A growth characteristic face is an inherent attribute of the SiC crystal prepared by the PVT method, a motion tendency of the growth characteristic face can be changed when the high-uniformity silicon carbide substrate grows by the PVT method in the present invention, so the growth characteristic face moves towards an edge of the crystal and is fixed within a range of 5 mm away from the edge of the crystal, the edge is cut during actual use of the crystal, and thus the silicon carbide substrate without the growth characteristic face may be obtained after the crystal is cut, ground, polished and the like.

Defects may be accumulated in the region due to existence of the growth characteristic face in an original substrate, more elements may also be induced to be accumulated at the growth characteristic face during an element doping process, so it is shown as non-uniform doping, electrical resistivity at the growth characteristic face is also higher than that of other regions, and carrier uniformity of the whole substrate is poor. Those limit large-scale application of the silicon carbide substrate.

The high-uniformity silicon carbide substrate in the present invention has no growth characteristic face, the whole substrate is in uniform distribution in both a radial direction and an axial direction, so generation and accumulation of defects can be restrained fundamentally, element accumulation in the doping process is also avoided, uniform element doping is achieved, thus doping uniformity, electrical resistivity uniformity and carrier uniformity of the substrate are improved, a device produced by adopting the silicon carbide substrate not only has good self performance, but also has good consistency of batch production, and it is beneficial for industrial popularization and application.

In some embodiments, a main doping element in n-type doping is an element N, and other elements may also be codoped besides the element N, for example, phosphorus, arsenic and other group-V elements; Ge, Sn and other group-IV elements; and B, Al and other group-III elements.

In some embodiments, the doping concentration change rate may be less than 8%; or the doping concentration change rate may be less than 5%; or the doping concentration change rate may be less than 3%.

In some embodiments, the carrier concentration change rate is less than 3%; or the carrier concentration change rate is less than 2%; or the carrier concentration change rate is less than 1%.

In some embodiments, the doping concentration is not higher than 5E19 cm⁻³, and the carrier concentration change rate is less than 5%.

In some embodiments, n-type element doping is N₂ doping, the doping concentration change rate is less than 3%, and the carrier concentration change rate is less than 1%.

The doping concentration change rate is "an in-plane doping concentration maximum value of the silicon carbide substrate minus an in-plane doping concentration minimum value of the silicon carbide substrate"; and the carrier concentration change rate is "an in-plane carrier concentration maximum value of the silicon carbide substrate minus an in-plane carrier concentration minimum value of the silicon carbide substrate".

The above N-type element doping concentration is greater than 1e18 cm⁻³ and belongs to medium-high nitrogen doping. For those skilled in the art, the higher the doping concentration is, the more prone to occurring a case of non-uniform doping. In a process of controlling the motion tendency of the growth characteristic face in the present invention, the growth characteristic face is fixed to the edge of the crystal, so that the doping uniformity can be improved in the doping process, and the electrical resistivity of the substrate is more uniform.

The carrier is related to the doping concentration and uniformity in the crystal. The carrier concentration change rate of the silicon carbide substrate in the present invention is less than 5%, which can represent that the silicon carbide substrate has a uniform carrier, thus it is conducive to improving quality of a photolithographic process of a downstream device end, and then device performance is improved.

In some embodiments, the silicon carbide substrate has a TDV density of less than 100 cm⁻². In some embodiments, the silicon carbide substrate has a TDV density of less than 50 cm⁻². In some embodiments, the silicon carbide substrate has a TDV density of less than 10 cm⁻². The total density variation (TDV for short) is defined as: dividing the substrate into several square boxes with a specific area, for example, n square boxes with an area of 1 mm x 1 mm, 2 mm x 2 mm, 5 mm x 5 mm, 10 mm x 10 mm, and a density of threading edge dislocation (TED for short) or threading screw dislocation (TSD for short) in the square boxes is d1, d2, d3...dn. TDV is a difference dmax-dmin between a TED/TSD density maximum value and a TED/TSD density minimum value. As the growth characteristic face is eliminated, the in-plane doping concentration of the silicon carbide substrate is uniform, the TDV is improved, and problems of dislocation and stacking fault defects in the silicon carbide substrate are eliminated.

In some embodiments, the silicon carbide substrate has a TED total density variation less than 100 cm⁻². In some embodiments, the silicon carbide substrate has the TED total density variation less than 50 cm⁻². In some embodiments, the silicon carbide substrate has the TED total density variation less than 10 cm⁻².

In the silicon carbide substrate of the present invention, as the growth characteristic face is eliminated, TED and TSD distribution is more uniform, so a TDV numerical value is low, which represents that whole dislocation distribution of the substrate is uniform, and the problem that overall defect density is low but local density is high in the current substrate is eliminated.

In some embodiments, the silicon carbide substrate has a basal plane dislocation (BPD for short) total density variation less than 50 cm⁻². In some embodiments, the silicon carbide substrate has the BPD total density variation less than 20 cm⁻². In some embodiments, the silicon carbide substrate has the BPD total density variation less than 10 cm⁻².

When a power electronic device is prepared with the above substrate, due to characteristics of a low doping concentration change rate value and a low carrier concentration change rate value, it can be guaranteed that the device has good electrical property and reliability in a process of producing the device.

In some embodiments, the silicon carbide substrate has a size which may be 4 inches, 6 inches, 8 inches, 10 inches or 12 inches.

A fifth aspect of the present invention provides a semiconductor device. The semiconductor device includes the SiC wafer or the high-uniformity silicon carbide substrate above.

In some embodiments, as the facet is an inherent attribute existing when the SiC crystal is prepared by a sublimation method, such facet region exits on both the SiC crystal and wafer prepared by a conventional physical vapor transportation method. In order to fix the facet to the edge position of the crystal and remove the facet in the subsequent crystal machining process so that no facet exists on the whole crystal bar as well as the wafer and the substrate obtained after subsequent machining, a machining manner of the SiC crystal with the facet at the edge in the present invention includes a crystal stable growth stage. Technical growth conditions of the crystal stable growth stage include the following steps:
S1: setting a discontinuous temperature gradient distribution in a radial direction of a crystal growth face, wherein a limiting edge exists close to a crystal growth edge, a distance between the limiting edge and the crystal growth edge is not greater than 6 mm, a continuous and positive temperature gradient is set from the limiting edge to a center of the crystal; and a temperature gradient within a range from the limiting edge to the crystal growth edge is greater than or equal to 2°C/cm, and a temperature gradient value within the range from the limiting edge to the crystal growth edge is greater than a temperature gradient value from the limiting edge to the center of the crystal;
S2: setting a deflection angle of a seed crystal in a crystal orientation in <11-20> or <1-100> or any other crystal orientation parallel to a c-face direction to be greater than 0°;
S3: setting an included angle α of a crystal growth graphite annulus in a direction parallel to crystal growth to be greater than 0°; and
S4: arranging sufficient silicon carbide powder between an inner wall of a crystal growth cavity and the crystal growth graphite annulus, so that it is guaranteed that a lateral growth of the SiC crystal has a sufficient reaction atmosphere, the SiC crystal can have a chemical environment of a continuous lateral growth, and the high-uniformity silicon carbide substrate is obtained by processing the SiC crystal.

In some embodiments, a temperature gradient within the range from the limiting edge to the crystal growth edge in step S1 is greater than or equal to 5°C/cm; and/or
the deflection angle of the seed crystal in a crystal orientation <11-20> in step S2 is greater than 2°; and/or
the included angle α of the crystal growth graphite annulus in the direction parallel to crystal growth in step S3 is greater than or equal to 8°.

In some embodiments, the distance between the limiting edge and the crystal growth edge is not greater than 5 mm.

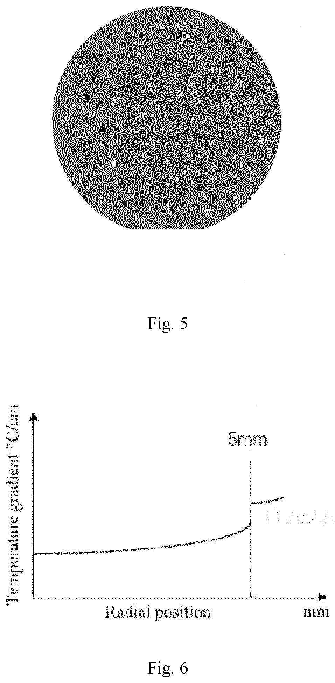

In some embodiments, in step S1: 5 mm away from the crystal growth edge is used as a boundary, the continuous and positive temperature gradient is set within a range of the distance away from the crystal growth edge being greater than 5 mm, value of the continuous and positive temperature gradient is less than or equal to 3°C/cm, and a temperature gradient value within a range of the distance away from the crystal growth edge being less than 5 mm is greater than or equal to 5°C/cm. For example, as shown in Fig. 6, an origin of coordinate axes represents a center of a wafer body, the discontinuous temperature gradient distribution is set in the radial direction of the crystal growth face, 5 mm away from the crystal growth edge is used as the boundary, a positive temperature gradient within the range of the distance away from the crystal growth edge being greater than 5 mm is a continuous smooth curve, and the temperature gradient within the range of the distance away from the crystal growth edge being less than 5 mm is greater than the temperature gradient within the range of the distance away from the crystal growth edge being greater than 5 mm.

A radial temperature gradient is calculated as a ratio of a difference (T2-T1) (between a temperature T1 of a point close to the center of the wafer body and a temperature T2 of a point farther from the center of the wafer body) to a distance d between the two points in a direction radiating outwards in a radial direction with the center of the wafer body as an origin, and a positive (positive direction) temperature gradient is ΔT=(T2-T1)/d; and otherwise, it is a negative temperature gradient ΔT=(T1-T2)/d.

The preparation method used by the present invention this time is that with setting of step S1, in a crystal growth process, the edge is also under continuous lateral growth and expanding, and by controlling the temperature gradient value within the range of being less than 6 mm away from the crystal growth edge to be greater than the temperature gradient value within the range of being greater than 6 mm away from the crystal growth edge in the crystal growth process in the present invention, sufficient lateral growth driving force of the crystal edge and continuous expanding growth capacity of the crystal edge are guaranteed. Through expanding growth, the growth characteristic face is driven to move towards the crystal edge so as to be fixed within the range of 5 mm away from the crystal edge, so that the high-uniformity silicon carbide substrate is obtained. However, those skilled in the art may understand that the motion tendency of the growth characteristic face may also be controlled in another manner, so as to obtain the silicon carbide substrate of the present invention, therefore, the present invention only illustrates the preparation method of the high-uniformity silicon carbide substrate obtained this time, and other methods for controlling the tendency of the growth characteristic face are beyond a study scope of the present invention.

The radial temperature gradient of crystal growth in step S1 may be set through a conventional technical means in the industry, for example, performing integrated adjustment by adjusting a temperature or a pressure in the growth cavity or a material thickness of a thermal insulation layer and other parameters. For setting a discontinuous temperature gradient, controllable adjustment of the temperature gradient may be implemented by performing structural improvement in the crystal growth cavity and optimizing a temperature distribution of a crystal growth interface, and if a material with a thermal conductivity lower than that of a center region is put at an edge of the crystal growth cavity to reduce heat loss of the edge so as to achieve temperature distribution jump at the crystal growth interface; and on the contrary, if a material with a higher thermal conductivity is put at the crystal growth edge or a thickness of the thermal insulation layer of the edge is reduced, or other solutions are adopted, a reverse temperature gradient distribution may be set. Besides, different thermal field structures or novel materials may also be arranged in the growth cavity for adjusting the temperature distribution. For example, a material coated with a TaC coating having a high reflectivity is arranged on the graphite annulus at the crystal growth edge, heat radiation in the growth cavity is centralized towards the crystal growth edge, so that the temperature gradient jump is achieved. The purpose of adjusting the temperature gradient in the crystal growth cavity is achieved by solution configuration according to actual demands through the above common technical means in the industry.

In some embodiments, in the crystal stable growth stage, the temperature in the growth cavity is first increased to 2200°C or above at a rate of 10-50°C/min, meanwhile, the pressure in the growth cavity is reduced to 1 mbar to 100 mbar, and then crystal growth is performed under arrangement of the steps S1-S4 and maintaining 50 h or above.

In some embodiments, in the crystal stable growth stage, the temperature in the growth cavity is first increased to 2200°C or above at a rate of 10-30°C/min, meanwhile, the pressure is reduced to 5 mbar to 50 mbar, and then crystal growth is performed under arrangement of the steps S1-S4 and maintaining 50 h or above.

In the present invention, the silicon carbide crystal is prepared by the PVT method, isostatic pressing formed graphite is used as a raw material of the growth cavity (crucible) in crystal growth, and SiC powder is used as a raw material of crystal growth. In order to guarantee excellent and stable electrical property of the silicon carbide, in some embodiments of the present invention, silicon carbide synthetic powder with a certain purity is used, a total impurity content of the silicon carbide powder is not higher than 1E19 cm⁻³. In some embodiments, the total impurity content in the silicon carbide powder is not higher than 1E17 cm⁻³.

In the present invention, during growth of the silicon carbide crystal, the SiC powder is put in a graphite crucible cavity, a SiC seed crystal is put at a top of the growth cavity, and then the crucible is sealed, put and wrapped in a heat-insulation heat preservation material prepared by graphite soft felt or hard felt and then transferred into a cavity of a crystal growth apparatus for crystal growth.

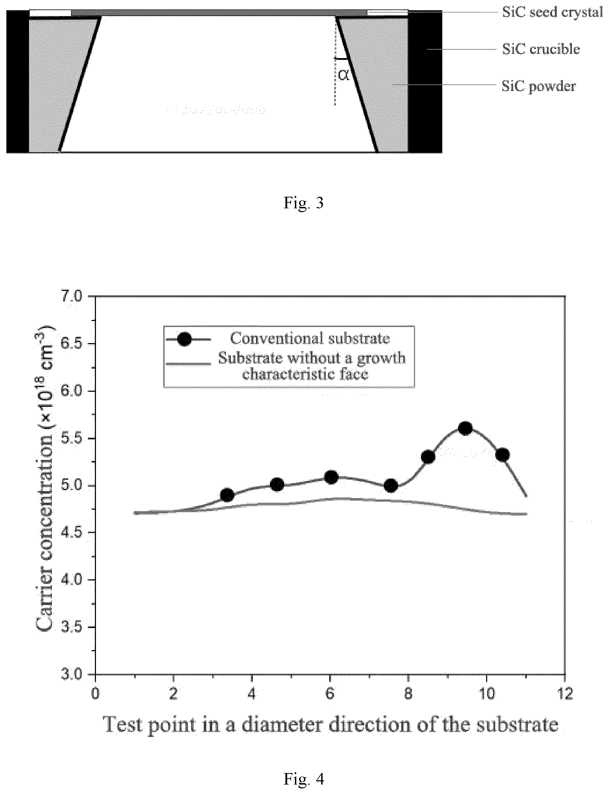

In the present invention, as shown in Fig. 3, a graphite support component is arranged on an upper portion of the SiC crucible, SiC powder is put between the graphite support component and a wall of the SiC crucible to serve as a material source of lateral growth, so that it is guaranteed that radial growth caused by the lateral growth of the crystal has sufficient expanding space. However, the present invention is not limited to this and may be designed in another manner.

In some embodiments, before the crystal stable growth stage, a crystal nucleation stage is further included, and technical growth conditions at the crystal nucleation stage include the following steps:
vacuumizing the growth cavity to 10⁻³ Pa or below after the crystal growth cavity is sealed, starting feeding inert gas after maintaining at the vacuum stage for a period of time, so that the pressure in the growth cavity is gradually increased to 100 mbar to 1000 mbar and keeps constant, and meanwhile, feeding nitrogen into the cavity at 1 ml/min to 100 ml/min.

In some embodiments, while the pressure in the growth cavity is increased at the crystal nucleation stage, the temperature in the growth cavity is gradually increased to 1600°C to 2100°C from a room temperature and then keeps constant, and after maintaining the constant temperature and constant pressure for 5 h to 50 h, the crystal stable growth stage is performed.

In some embodiments, the temperature in the growth cavity in the crystal nucleation stage is constant at 1800°C to 2100°C, the pressure in the growth cavity is constant at 300 mbar to 800 mbar, and after maintaining the constant temperature and constant pressure for 30 h to 50 h, the crystal stable growth stage is performed.

In the crystal nucleation stage, the silicon carbide powder is sublimated to form a crystal nucleus, then in the crystal stable growth stage, the silicon carbide powder can be fully sublimated and transported to the seed crystal for stable growth, and finally the silicon carbide crystal is obtained. A diameter of the seed crystal is at least 5 mm greater than a diameter of a target crystal and a substrate, so the prepared SiC crystal has an edge machining allowance, and the edge is cut so as to obtain the high-uniformity silicon carbide crystal. Meanwhile, smooth preparation of the large-size silicon carbide substrate can be guaranteed, and quality of the prepared silicon carbide substrate can also be improved.

Compared with the prior arts, the present invention at least has one of the following beneficial effects.
(1) In the present invention, the facet region of the SiC crystal with facets only in edge area is directly fixed to the outer circumference of the SiC crystal in a growth process of the PVT method, and the facet region is removed in the subsequent crystal machining process, so that the facet region does not exist on the whole crystal bar as well as the wafer and the substrate which are obtained after subsequent machining with the low cut loss rate, production cost of the silicon carbide crystal is reduced, and meanwhile, the silicon carbide crystal with fewer defects and high uniformity is guaranteed.
(2) The silicon carbide wafer in the present invention has high uniformity, for example, doping uniformity, carrier uniformity and the like. Besides, the silicon carbide wafer in the present invention has no facet visible to the naked eyes.
(3) The silicon carbide substrate in the present invention has no facet visible to the naked eyes, within the full area range, the doping concentration change rate is less than 10%, the carrier concentration change rate is less than 5%, which thus represents that the silicon carbide substrate has high uniformity, and the semiconductor device prepared by using the silicon carbide substrate has a higher yield, higher performance and higher reliability.
(4) In the present invention, the silicon carbide substrate has the TDV density of less than 100 cm⁻² within the full area range, the problems of low overall defect density and high local density in an existing substrate are eliminated, and defects such as dislocations and stacking faults hardly exist, which is more suitable for being popularized and applied in a large scale.
(5) The silicon carbide substrate in the present invention has high uniformity, for example, doping uniformity, carrier uniformity and the like. When the substrate is cut for preparing the semiconductor device, an effective area utilization rate can be improved, and compared with other substrates with the same area, the prepared semiconductor device not only has good performance, but also has a large number, and production cost of the semiconductor device may be reduced.

### BRIEF DESCRIPTION OF THE DRAWINGS

The above and/or additional aspects and advantages of the present invention will be clear and easy to understand from the description of embodiments with reference to the following accompanying drawings.
Fig. 1 shows an exemplary embodiment of a schematic structural diagram of a silicon carbide substrate with a facet visible to naked eyes.
Fig. 2 shows an exemplary embodiment of a schematic diagram of a facet growth process in the present invention.
Fig. 3 shows an exemplary embodiment of a schematic structural diagram of growth of a silicon carbide crystal in the present invention.
Fig. 4 shows a contrast diagram of a carrier concentration of a silicon carbide substrate in Embodiment 2 and a carrier concentration of a silicon carbide substrate in Comparative example 1.
Fig. 5 shows an exemplary embodiment of a schematic structural diagram of a silicon carbide substrate without a growth characteristic face.
Fig. 6 shows an exemplary embodiment of a schematic diagram of a discontinuous temperature gradient set in a radial direction of a crystal growth face in the present invention.

### DETAILED DESCRIPTION OF THE EMBODIMENTS

To more clearly understand the above objectives, features, and advantages of the present invention, the following further describes the present invention in detail with reference to the accompanying drawings and specific embodiments. It needs to be noted that the embodiments in the present invention and features in the embodiments may be mutually combined without conflicts.

Many specific details are set forth in the following description to facilitate a full understanding of the present invention, but the present invention may alternatively be implemented in other manners different from those described herein, and therefore, the protection scope of the present invention is not limited by the specific embodiments disclosed below.

In a process of preparing a silicon carbide crystal in the following Embodiment 1 to Embodiment 6, a growth characteristic face can be locked to an edge of the silicon carbide crystal, and the silicon carbide substrate without the growth characteristic face is obtained along with cutting the edge of the crystal. Due to absence of the growth characteristic face which is an inherent structural attribute, the number of defects of the silicon carbide substrate is reduced without accumulation, meanwhile, elements in doping can be prevented from being accumulated, namely, existence of a highly-doped region is avoided, and thus doping uniformity and carrier uniformity of the silicon carbide substrate of this structure without the growth characteristic face are both improved.

### Embodiment 1

The present embodiment relates to a method for preparing a 6-inch high-uniformity silicon carbide substrate, specifically including the following steps:
(1) a crystal nucleation stage
   silicon carbide powder and a seed crystal are put in a crucible, then a growth cavity is sealed, the growth cavity is vacuumized to 10⁻³ Pa or below through a mechanical pump and a vacuum pump, feeding inert gas is started after stabilization at the vacuum stage for a period of time, so that a pressure in the growth cavity is gradually increased to 100 mbar, and meanwhile, nitrogen is fed into the cavity at 10 ml/min. While the pressure in the growth cavity is increased at the crystal nucleation stage, the temperature in the growth cavity is gradually increased to 1600°C from a room temperature through power setting and is kept for 10 h.
(2) A crystal stable growth stage

After the crystal nucleation stage is completed, the temperature is increased to 2300°C at a rate of 20°C/min, and meanwhile, the pressure in the growth cavity is reduced to 3 mbar by regulating a pressure controller and is kept for 60 h. Specifically,
S1: a discontinuous temperature gradient distribution is set in a radial direction of a crystal growth face, 3 mm away from a crystal growth edge is used as a boundary, a continuous and positive temperature gradient is set within a range of being greater than 4 mm away from the crystal growth edge, and value of the continuous and positive temperature gradient is 5°C/cm; and a temperature gradient within a range of being less than 4 mm away from the crystal growth edge is 10°C/cm, so that sufficient lateral growth driving force of the crystal edge is guaranteed, and continuous expanding growth capacity of the crystal edge is guaranteed.
S2: a deflection angle of the seed crystal in a crystal orientation <11-20> is set to be 1.5°.
S3: an included angle α of a crystal growth graphite annulus in a direction parallel to crystal growth is set to be 10°, so that it is guaranteed that radial growth caused by crystal lateral growth has sufficient expanding space.
S4: sufficient silicon carbide powder is arranged between an inner wall of a crystal growth cavity and the crystal growth graphite annulus, so that it is guaranteed that a lateral growth of the SiC crystal has a sufficient reaction atmosphere, and the SiC crystal can have a chemical environment of a continuous lateral growth. The crystal obtained after growth is cut, ground, polished and subjected to other machining, so as to obtain a target silicon carbide substrate.

### Embodiment 2

The present embodiment relates to a method for preparing a 6-inch high-uniformity silicon carbide substrate, specifically including the following steps:
(1) a crystal nucleation stage
   silicon carbide powder and a seed crystal are put in a crucible, then a growth cavity is sealed, the growth cavity is vacuumized to 10⁻³ Pa or below through a mechanical pump and a vacuum pump, feeding inert gas is started after stabilization at the vacuum stage for a period of time, so that a pressure in the growth cavity is gradually increased to 400 mbar, and meanwhile, nitrogen is fed into the cavity at 40 ml/min. While the pressure in the growth cavity is increased at the crystal nucleation stage, the temperature in the growth cavity is gradually increased to 1900°C from a room temperature through power setting and is kept for 40 h.
(2) A crystal stable growth stage

After the crystal nucleation stage is completed, the temperature is increased to 2500°C at a rate of 30°C/min, and meanwhile, the pressure in the growth cavity is reduced to 20 mbar by regulating a pressure controller and is kept for 60 h. Specifically,
S1: a discontinuous temperature gradient distribution is set in a radial direction of a crystal growth face, 5 mm away from a crystal growth edge is used as a boundary, a continuous and positive temperature gradient is set within a range of being greater than 5 mm away from the crystal growth edge, and value of the continuous and positive temperature gradient is 2°C/cm; and a temperature gradient within a range of being less than 5 mm away from the crystal growth edge is 8°C/cm, so that sufficient lateral growth driving force of the crystal edge is guaranteed, and continuous expanding growth capacity of the crystal edge is guaranteed.
S2: a deflection angle of the seed crystal in a crystal orientation <11-20> is set to be 1°.
S3: an included angle α of a crystal growth graphite annulus in a direction parallel to crystal growth is set to be 8°, so that it is guaranteed that radial growth caused by crystal lateral growth has sufficient expanding space.
S4: sufficient silicon carbide powder is arranged between an inner wall of a crystal growth cavity and the crystal growth graphite annulus, so that it is guaranteed that a lateral growth of the SiC crystal has a sufficient reaction atmosphere, and the SiC crystal can have a chemical environment of a continuous lateral growth. The crystal obtained after growth is cut, ground, polished and subjected to other machining, so as to obtain a target silicon carbide substrate.

### Embodiment 3

The present embodiment relates to a method for preparing a 6-inch high-uniformity silicon carbide substrate, specifically including the following steps:
(1) a crystal nucleation stage
   silicon carbide powder and a seed crystal are put in a crucible, then a growth cavity is sealed, the growth cavity is vacuumized to 10⁻³ Pa or below through a mechanical pump and a vacuum pump, feeding inert gas is started after stabilization at the vacuum stage for a period of time, so that a pressure in the growth cavity is gradually increased to 900 mbar, and meanwhile, nitrogen is fed into the cavity at 60 ml/min. While the pressure in the growth cavity is increased at the crystal nucleation stage, the temperature in the growth cavity is gradually increased to 2000°C from a room temperature through power setting and is kept for 40 h.
(2) A crystal stable growth stage

After the crystal nucleation stage is completed, the temperature is increased to 2700°C at a rate of 40°C/min, and meanwhile, the pressure in the growth cavity is reduced to 40 mbar by regulating a pressure controller and is kept for 60 h. Specifically,
S1: a discontinuous temperature gradient distribution is set in a radial direction of a crystal growth face, 2 mm away from a crystal growth edge is used as a boundary, a continuous and positive temperature gradient is set within a range of being greater than 3 mm away from the crystal growth edge, and value of the continuous and positive temperature gradient is 3°C/cm; and a temperature gradient within a range of being less than 3 mm away from the crystal growth edge is 12°C/cm, so that sufficient lateral growth driving force of the crystal edge is guaranteed, and continuous expanding growth capacity of the crystal edge is guaranteed.
S2: a deflection angle of the seed crystal in a crystal orientation <11-20> is set to be 3°.
S3: an included angle α of a crystal growth graphite annulus in a direction parallel to crystal growth is set to be 10°, so that it is guaranteed that radial growth caused by crystal lateral growth has sufficient expanding space.
S4: sufficient silicon carbide powder is arranged between an inner wall of a crystal growth cavity and the crystal growth graphite annulus, so that it is guaranteed that a lateral growth of the SiC crystal has a sufficient reaction atmosphere, and the SiC crystal can have a chemical environment of a continuous lateral growth. The crystal obtained after growth is cut, ground, polished and subjected to other machining, so as to obtain a target silicon carbide substrate.

### Embodiment 4

The present embodiment relates to a method for preparing a 6-inch high-uniformity silicon carbide substrate, specifically including the following steps:
(1) a crystal nucleation stage
   silicon carbide powder and a seed crystal are put in a crucible, then a growth cavity is sealed, the growth cavity is vacuumized to 10⁻³ Pa or below through a mechanical pump and a vacuum pump, feeding inert gas is started after stabilization at the vacuum stage for a period of time, so that a pressure in the growth cavity is gradually increased to 300 mbar, and meanwhile, nitrogen is fed into the cavity at 40 ml/min. While the pressure in the growth cavity is increased at the crystal nucleation stage, the temperature in the growth cavity is gradually increased to 1800°C from a room temperature through power setting and is kept for 30 h.
(2) A crystal stable growth stage

After the crystal nucleation stage is completed, the temperature is increased to 2400°C at a rate of 30°C/min, and meanwhile, the pressure in the growth cavity is reduced to 10 mbar by regulating a pressure controller and is kept for 70 h. Specifically,
S1: a discontinuous temperature gradient distribution is set in a radial direction of a crystal growth face, 1 mm away from a crystal growth edge is used as a boundary, a continuous and positive temperature gradient is set within a range of being greater than 4.5 mm away from the crystal growth edge, and value of the continuous and positive temperature gradient is 2°C/cm; and a temperature gradient within a range of being less than 4.5 mm away from the crystal growth edge is 4°C/cm, so that sufficient lateral growth driving force of the crystal edge is guaranteed, and continuous expanding growth capacity of the crystal edge is guaranteed.
S2: a deflection angle of the seed crystal in a crystal orientation <11-20> is set to be 0.5°.
S3: an included angle α of a crystal growth graphite annulus in a direction parallel to crystal growth is set to be 20°, so that it is guaranteed that radial growth caused by crystal lateral growth has sufficient expanding space.
S4: sufficient silicon carbide powder is arranged between an inner wall of a crystal growth cavity and the crystal growth graphite annulus, so that it is guaranteed that a lateral growth of the SiC crystal has a sufficient reaction atmosphere, and the SiC crystal can have a chemical environment of a continuous lateral growth. The crystal obtained after growth is cut, ground, polished and subjected to other machining, so as to obtain a target silicon carbide substrate.

### Embodiment 5

The present embodiment has a main difference from Embodiment 2 that in step S1, a temperature gradient within a range of being less than 5 mm away from the crystal growth edge is 6°C/cm, the present embodiment prepares an 8-inch silicon carbide substrate, and the other steps are the same as those in Embodiment 2.

### Embodiment 6

The present embodiment has a main difference from Embodiment 2 that in step S1, a continuous and positive temperature gradient is set within a range of being greater than 5 mm away from the crystal growth edge, value of the continuous and positive temperature gradient is 7°C/cm, the present embodiment prepares an 8-inch silicon carbide substrate, and the other steps are the same as those in Embodiment 2.

### Comparative example 1

The present comparative example has a difference from Embodiment 2 that in step S1, a continuous and positive temperature gradient is set from a center of the crystal to an edge of the crystal, the continuous and positive temperature gradient is 3°C/cm, and the other steps are the same as those in Embodiment 2.

### Comparative example 2

The present comparative example has a difference from Embodiment 2 that in step S1, a temperature gradient within a range of being less than 5 mm away from the crystal growth edge is 1°C/cm, and the other steps are the same as those in Embodiment 2.

Specifically, parameters of machining methods in Embodiment 1 to Embodiment 6 are shown in Table 1.

**Table 1 Table of parameters of machining methods**

| | Doping Element | A position/m m away from a crystal growth edge | A temperature gradient value less than the position away from the crystal growth edge | A deflection angle of a seed crystal in a crystal orientation <11-20> | Included angle α |
|---|---|---|---|---|---|
| Embodiment 1 | N₂ | 4 mm | 10°C/cm | 1.5° | 10° |
| Embodiment 2 | N₂ | 5 mm | 8°C/cm | 1° | 8° |
| Embodiment 3 | N₂ | 3 mm | 12°C/cm | 3° | 10° |
| Embodiment 4 | N₂ | 4.5 mm | 4°C/cm | 0.5° | 20° |
| Embodiment 5 | N₂ | 5 mm | 6°C/cm | 1° | 8° |
| Embodiment 6 | N₂, P | 5 mm | 8°C/cm | 1° | 8° |

### Experimental example 1

A position test for a facet region in a SiC crystal with facets only in edge area prepared by the above method is shown in Table 2. A volume of the facet region may be calculated by a calculus or modeling manner.

**Table 2 Table of a position test for a facet region in a crystal**

| | Size/ Inch | A distance/mm between the facet region and the crystal edge | A proportion/% for which a maximum sectional area of the facet region accounts of a cross sectional area of the crystal in a diameter direction | A proportion/% for which a volume of the facet region accounts of a volume of the whole crystal |
|---|---|---|---|---|
| Embodiment 1 | 6 | 3.5 | 10 | 5 |
| Embodiment 2 | 6 | 3.1 | 4 | 0.4 |
| Embodiment 3 | 6 | 2.5 | 5 | 1 |
| Embodiment 4 | 6 | 3 | 8 | 0.6 |
| Embodiment 5 | 8 | 4.3 | 10 | 3 |
| Embodiment 6 | 8 | 4.1 | 7 | 2.5 |
| Comparative example 1 | 6 | 60 | 70 | 10 |
| Comparative example 2 | 6 | 70 | 30 | 12 |

As shown in Table 2, it may be seen that in the SiC crystal with facets only in edge area in the present invention, the facet region is directly controlled on an outer circumference away from the crystal in a PVT production process, the facet is driven to move to an external region of the crystal with a target diameter, and in the subsequent crystal machining process, the facet region may be removed with a lower cut loss rate, so as to obtain the SiC crystal with fewer defects. In Comparative example 1 and Comparative example 2, the facet region is located in a middle position and within a range of the target diameter of the crystal, which results in that a device end obtained after subsequent machining has a lower yield, lower performance and lower reliability.

The SiC crystal with facets only in edge area obtained by the embodiment is machined, a SiC wafer is obtained by removing the facet region and direct cutting, those obtained by Comparative example 1 and Comparative example 2 are cut to form a silicon carbide wafer, and a performance test of the SiC wafers is shown in Table 3.

The doping concentration change rate is "an in-plane doping concentration maximum value minus an in-plane doping concentration minimum value"; and the carrier concentration change rate is "an in-plane carrier concentration maximum value minus an in-plane carrier concentration minimum value".

**Table 3 Table of a performance test**

| | Whether a facet is included | Wafer thickness/ µm | Doping concentration/ cm⁻³ | Doping concentration change rate | Carrier concentration change rate | **TDV** /cm⁻² |
|---|---|---|---|---|---|---|
| Embodiment 1 | No | 350 | 2E¹⁸ | 1.8% | 2% | 40 |
| Embodiment 2 | No | 350 | 5E¹⁸ | 1.2% | 1% | 8 |
| Embodiment 3 | No | 350 | 7E¹⁸ | 1.7% | 3% | 45 |
| Embodiment 4 | No | 200 | 5E¹⁸ | 2.8% | 2.5% | 90 |
| Embodiment 5 | No | 500 | 5E¹⁸ | 2.4% | 5% | 100 |
| Embodiment 6 | No | 350 | 5E¹⁸ | 1.6% | 6% | 88 |
| Comparative example 1 | Yes | 350 | 5E¹⁸ | 13% | 60% | 500 |
| Comparative example 2 | Yes | 358 | 5E¹⁸ | 30% | 35% | 450 |

As shown in Table 3, it may be seen that the silicon carbide wafer obtained in the present invention has high uniformity, for example, doping uniformity, carrier uniformity and the like. Besides, the silicon carbide wafer in the present invention has no facet visible to the naked eyes.

Based on Embodiment 1 to Embodiment 3, the SiC crystal with facets only in edge area obtained by Embodiment 1 to Embodiment 3 is directly cut respectively to obtain the silicon carbide wafer including the facet, and a performance test is performed on the obtained silicon carbide wafer including the facet, as shown in Table 4.

**Table 4 Table of a test for a silicon carbide wafer including a facet**

| | Wafer thickness/ µm | A doping concentration change rate of the facet region/a doping concentration change rate of the non-facet region | A carrier concentration change rate of the facet region/a carrier concentration change rate of the non-facet region | A TDV of the facet region/a TDV of the non-facet region |
|---|---|---|---|---|
| Embodiment 1 | 350 | 3.0 | 7.1 | 8.4 |
| Embodiment 2 | 350 | 1.7 | 5.5 | 6.5 |
| Embodiment 3 | 500 | 5.6 | 11.5 | 15.2 |
| Embodiment 4 | 200 | 2.2 | 4.2 | 8.7 |

As shown in Table 4, it may be seen that the doping concentration change rate of the facet region is 1.5 times or above the doping concentration change rate of the non-facet region; the carrier concentration change rate of the facet region is 4 times or above the carrier concentration change rate of the non-facet region; and the TDV of the facet region is 6 times or above the TDV of the non-facet region.

In the present invention, the SiC crystal with facets only in edge area is obtained directly through growth by the PVT method without subsequent machining, the facet region is fixed to the outer circumference of the SiC crystal, and the facet region is removed in the subsequent crystal machining process, so that the facet region does not exist on the whole crystal bar as well as the wafer and the substrate which are obtained after subsequent machining with the low cut loss rate, production cost of the silicon carbide crystal is reduced, and meanwhile, the silicon carbide wafer with fewer defects and high uniformity is guaranteed.

### Experimental example 2

The above embodiments and the comparative examples prepare the silicon carbide crystal by the PVT crystal growth method and also use the same edge cutting (cutting by 5 mm), radial cutting, grinding and polishing procedures to obtain the silicon carbide substrate, a performance test is performed on the obtained silicon carbide substrate sample, and a result is shown in Table 5.

**Table 5 Table of a performance test**

| | Whether a growth characteristic face is included | Thickness /µm | Doping concentration /cm⁻³ | Doping concentration change rate | Carrier concentration change rate | TDV /cm⁻² |
|---|---|---|---|---|---|---|
| Embodiment 1 | No | 350 | 2E¹⁸ | 1.8% | 2% | 40 |
| Embodiment 2 | No | 350 | 5E¹⁸ | 1.2% | 1% | 8 |
| Embodiment 3 | No | 350 | 7E¹⁸ | 1.7% | 3% | 45 |
| Embodiment 4 | No | 200 | 5E¹⁸ | 2.8% | 2.5% | 90 |
| Embodiment 5 | No | 500 | 5E¹⁸ | 2.4% | 5% | 100 |
| Embodiment 6 | No | 350 | 5E¹⁸ | 1.6% | 4% | 87 |
| Comparative example 1 | Yes | 350 | 5E¹⁸ | 13% | 70% | 500 |
| Comparative example 2 | Yes | 200 | 5E¹⁸ | 30% | 35% | 450 |

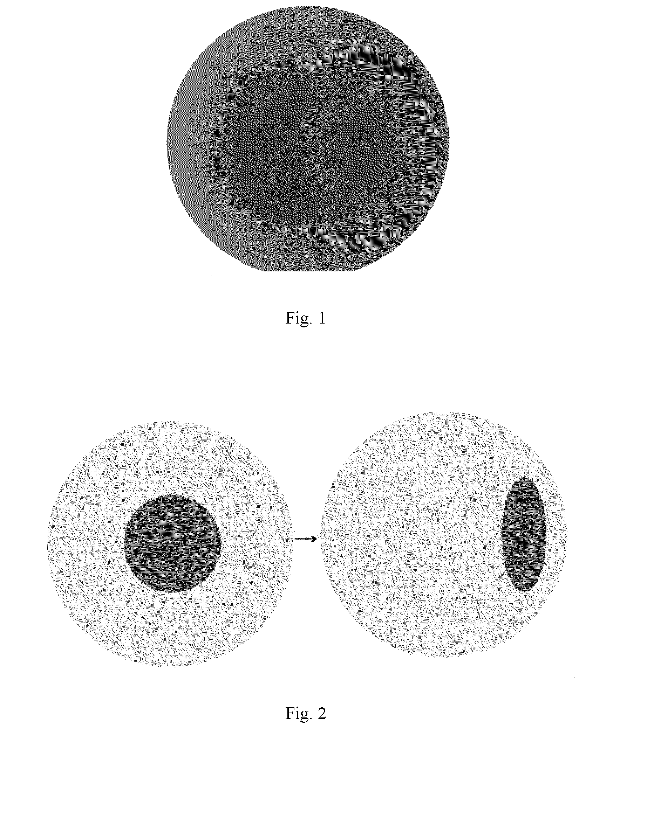

The discontinuous temperature gradient distribution is set in the radial direction of the crystal growth face in the present invention, so that the sufficient lateral growth driving force of the crystal edge is guaranteed, and the continuous expanding growth capacity of the crystal edge is guaranteed. The crystals in the embodiments and the comparative examples are subjected to the same convention edge cutting, radial cutting, grinding and polishing processes without changing the quality of the substrate. Therefore, it may be known according to data of Table 2 that the preparation method of the present invention can control the motion tendency of the growth characteristic face and lock the same to the crystal edge, and control over the motion tendency refers to Fig. 2. The growth characteristic face at the crystal edge can be removed with cutting of the crystal edge, so the substrates in Embodiment 1 to Embodiment 6 do not have the growth characteristic face, but the existing positive temperature gradient in Comparative example 1 and the temperature gradient of 1°C/mm at the edge in Comparative example 2 cannot make the growth characteristic face move towards the edge and fix the same to the edge.

The silicon carbide substrate in Comparative example 1 or Comparative example 2 includes the growth characteristic face visible to the naked eyes, a structure thereof is shown in Fig. 1, and it may be seen that no "birthmark"-like black spot is included within the full area range of the silicon carbide substrate without the growth characteristic face. The silicon carbide substrates prepared in Embodiment 1 to Embodiment 6 do not include the growth characteristic face visible to the naked eyes, and a structure thereof is shown in Fig. 5. It may be known from the above embodiments and comparative example as well as Fig. 1 and Fig. 5 that the silicon carbide substrate without the growth characteristic face is obtained by the preparation method in the present invention, it may be known with reference to other parameters disclosed in Table 5 that due to absence of the growth characteristic face, the in-plane doping concentration change rate of the silicon carbide substrate is less than 10%, its carrier concentration change rate is less than 5%, and its TDV density is less than 200 cm⁻², which represents that the whole performance of the silicon carbide substrate is improved. However, in Comparative example 1 and Comparative example 2, the in-plane doping concentration change rate of the silicon carbide substrate with the growth characteristic face is greater than 15%, its carrier concentration change rate is greater than 50%, and its TDV is greater than 450 cm⁻², which represents that the whole performance of the silicon carbide substrate is poor.

As shown in Fig. 4, a horizontal coordinate represents a test point in the diameter direction of the substrate, and a vertical coordinate represents a carrier concentration. A curve without black dots Fig. 4 is a curve diagram of a carrier concentration change of the silicon carbide substrate without the growth characteristic face in the diameter direction in Embodiment 2 in the present invention; and a curve with black dots is a curve diagram of a carrier concentration change of a conventional substrate in a diameter direction in Comparative example 1. It may be seen in Fig. 4 that in the conventional silicon carbide substrate with the growth characteristic face, an apparent high-concentration nitrogen-doping region and a high-carrier-concentration region may appear in a growth characteristic face region in the diameter direction, the electrical resistivity in the region is remarkably lower than that of other regions, which leads to non-uniform distribution of the in-plane electrical resistivity of the substrate; besides, the high-nitrogen doping region is prone to being a region with the highest crystal growth rate and causing defects such as the threading edge dislocation; and the high-concentration carrier region may also cause transformation and extending from the basal plane dislocation to stacking fault during epitaxy and device use, thereby affecting the device yield, performance and ultimate reliability.

In the present invention, due to elimination of the growth characteristic face, the doping uniformity and the carrier uniformity in the substrate are improved substantially, no accumulation of wrappages or dislocations, micropipes and other defects at the growth characteristic face usually existing in the conventional substrate exists in the substrate, and substrate quality and yield are substantially improved; and the performance and reliability of the substrate will be substantially improved during subsequent device processing and use.

Elimination of the growth characteristic face is completed in the crystal growth stage, and the subsequent substrate machining technique does not affect the above electrical performance, so the present invention has no special limit on a substrate machining manner, which is a conventional operation for those skilled in the art. Such growth solution is simple and easy to implement, and stress and defect control under the continuous small temperature gradient of the center region of the crystal can be guaranteed. The growth characteristic face may be fixed to the edge position of the crystal through above innovation and removed in the subsequent crystal machining process, so that the growth characteristic face does not exist on the whole crystal bar and the substrate which is obtained after subsequent machining, the purpose of eliminating the defect accumulation region is achieved, and the yield and reliability of the device end are guaranteed.

However, the method for preparing the silicon carbide substrate without the growth characteristic face in the present invention includes but is not limited to this. Those skilled in the art may also prepare the silicon carbide substrate by using another manner of controlling the characteristic growth face, so the preparation method disclosed in the present invention is only exemplary instead of constituting a limitation on the self performance of the silicon carbide substrate. Those skilled in the art may also obtain the silicon carbide substrate of the present invention by studying a new preparation method through an existing technical reserve and creative labor, and the other preparation methods are not within the study scope of the present invention and are therefore not studied.

The above is only related to preferred embodiments of the present invention and is not intended to limit the present invention. The present invention may have various variations and changes for those skilled in the art. Any modification, equivalent replacement, or improvement made without departing from the spirit and principle of the present invention shall fall within the protection scope of the present invention.

## Claims

1. A SiC crystal with facets only in edge area, wherein the SiC crystal is obtained through direct growth by a PVT method without subsequent machining, the SiC crystal comprises a facet region and a non-facet region, the facet region is located on an outer circumference of the SiC crystal, and the whole area of the facet region meets any one or two of the following items a to b:
a, a doping concentration change rate of the facet region is 1.5 times or above a doping concentration change rate of the non-facet region; and
b, a carrier concentration change rate of the facet region is 5 times or above a carrier concentration change rate of the non-facet region.

2. The SiC crystal according to claim 1, wherein a distance between the outer circumference and an edge of the facet region away from the outer circumference does not exceed 3% of a diameter of the SiC crystal.

3. The SiC crystal according to claim 1, wherein a maximum sectional area of the facet region accounts for 10% or below of a cross sectional area of the crystal in a diameter direction; and/or
a volume of the facet region accounts for 2% or below of a volume of the whole crystal.

4. The SiC crystal according to claim 3, wherein a maximum sectional area of the facet region accounts for 5% or below of a cross sectional area of the crystal in a diameter direction; and/or
a volume of the facet region accounts for 0.6% or below of a volume of the whole crystal.

5. The SiC crystal according to claim 1, wherein a TDV of the facet region is 6 times or above a TDV of the non-facet region.

6. The SiC crystal according to claim 5, wherein a TDV of the facet region is 10 times or above a TDV of the non-facet region.

7. The SiC crystal according to claim 1, wherein a doping concentration change rate of the facet region is 5 times or above a doping concentration change rate of the non-facet region; and/or
a carrier concentration change rate of the facet region is 10 times or above a carrier concentration change rate of the non-facet region.

8. A facet-free silicon carbide crystal bar, wherein the facet-free silicon carbide crystal bar is obtained by removing the facet region of the SiC crystal with facets only in edge area according to any one of claims 1 to 7.

9. A high-uniformity silicon carbide substrate, wherein the high-uniformity silicon carbide substrate is obtained by machining the SiC crystal according to any one of claims 1 to 7, the silicon carbide substrate is of a conductive type, and the whole area of the silicon carbide substrate meets any one or two of the following items a to b:
a, a doping concentration change rate is less than 10%; and
b, a carrier concentration change rate is less than 5%.

10. The high-uniformity silicon carbide substrate according to claim 9, wherein the silicon carbide substrate is n-type doping, an n-type element doping concentration is greater than or equal to 1E¹⁸cm⁻³, and the whole area does not contain any one or two or more of the following: a growth characteristic face, a highly-doped region, a defect accumulation region.

11. The high-uniformity silicon carbide substrate according to claim 9, wherein the doping concentration change rate is less than 8%.

12. The high-uniformity silicon carbide substrate according to claim 9, wherein the carrier concentration change rate is less than 3%.

13. The high-uniformity silicon carbide substrate according to claim 10, wherein when a doping concentration is not higher than 5E¹⁹cm⁻³, the carrier concentration change rate is less than 5%.

14. The high-uniformity silicon carbide substrate according to claim 10, wherein n-type element doping is N₂ doping, the doping concentration change rate is less than 3%, and the carrier concentration change rate is less than 1%.

15. The high-uniformity silicon carbide substrate according to claim 9, wherein the silicon carbide substrate has a TDV density of less than 100 cm⁻².

16. The high-uniformity silicon carbide substrate according to claim 15, wherein the silicon carbide substrate has a TDV density of less than 10 cm⁻².

17. The high-uniformity silicon carbide substrate according to claim 9, wherein the silicon carbide substrate has a size of 6 inches, 8 inches, 10 inches or 12 inches.

18. A semiconductor device, wherein the semiconductor device comprises the high-uniformity silicon carbide substrate according to claim 9.
